# FASCICULE DE BREVET EUROPEEN

(11) **EP 4 513 269 B1**
(45) Date de publication et mention de la délivrance du brevet: **25.03.2026**
(21) Numéro de dépôt: 24194194.7
(22) Date de dépôt: 12.08.2024
(51) Int. Cl.: G03F 7/00, H01L 21/02, H01L 21/027, H01L 21/308, H01L 21/32

(54) **PROCEDE DE STRUCTURATION D'UN SUBSTRAT**
VERFAHREN ZUR STRUKTURIERUNG EINES SUBSTRATS
METHOD FOR STRUCTURING A SUBSTRATE

(30) Priorité: 18.08.2023 FR 2308800
(43) Date de publication de la demande: 26.02.2025
(73) Titulaire: Commissariat à l'Energie Atomique et aux Energies Alternatives, 75015 Paris (FR)
(72) Inventeur: MONTMEAT, Pierre, 38054 Grenoble Cedex 09 (FR); FOURNEL, Franck, 38054 Grenoble Cedex 09 (FR)
(74) Mandataire: Cabinet Beaumont

(56) Documents cités:
- US-A1- 2005 263 025
- US-A1- 2011 017 705
- LEE SANG HUN ET AL: "Multifunctional self-assembled monolayers via microcontact printing and degas-driven flow guided patterning", vol. 8, no. 1, 1 January 2018 (2018-01-01), pages 16763, XP093045595, Retrieved from the Internet <URL:https://www.nature.com/articles/s41598-018-35195-9.pdf> DOI: 10.1038/s41598-018-35195-9

## Description

### Domaine technique

La présente description concerne de façon générale le domaine de la microélectronique et plus particulièrement la réalisation de motifs sur un substrat en vue de la fabrication de composants microélectroniques.

### Technique antérieure

L'élaboration de composants microélectroniques nécessite la réalisation de motifs sur un substrat par photolithographie.

La photolithographie est réalisée au travers de différentes étapes mettant en œuvre une résine : étalement de la résine sur un substrat, insolation de la résine au moyen d'un masque, développement, gravure puis retrait de la résine (ou « stripping »). L'étape de retrait (ou nettoyage de la résine) est une étape complexe car elle nécessite de trouver un agent de nettoyage suffisamment agressif pour nettoyer parfaitement la résine tout en préservant l'intégrité des différentes surfaces.

Pour chaque substrat sur lequel des composants microélectroniques doivent être réalisés, ces différentes étapes sont répétées. Or**,** ces étapes sont, non seulement, longues à mettre en œuvre, mais, en plus, elles engendrent des coûts importants, dus notamment à l'utilisation des résines, des solvants et des solutions de nettoyage utilisés.

Les documents US 2005/263025 A1 et US 2011/017705 A1 proposent des procédés alternatifs.

### Résumé de l'invention

Il existe un besoin d'obtenir un procédé qui permet de réaliser des motifs sur un substrat tout en limitant les coûts et la durée du procédé par rapport aux procédés actuels.

Ce but est atteint par un procédé de réalisation de motifs sur un substrat comprenant les étapes suivantes :
a) Coller un substrat-poignée sur un substrat d'intérêt, le substrat-poignée comprenant une base et des éléments en relief recouvrant la base, le substrat d'intérêt comprenant un substrat support recouvert par une couche mince, la couche mince comprenant un matériau sensible à un agent de gravure, moyennant quoi la couche mince comprend des premières zones non recouvertes par les éléments en relief et des deuxièmes zones recouvertes par les éléments en relief,
b) Former une couche hydrophobe sur les premières zones de la couche mince, par exemple en mettant en contact l'ensemble obtenu à l'étape a) avec une solution comprenant un composé hydrophobe,
c) Séparer le substrat-poignée du substrat d'intérêt,
d) Mettre en contact le substrat d'intérêt avec une solution aqueuse comprenant l'agent de gravure, moyennant quoi on grave le matériau sensible à l'agent de gravure présent dans les deuxièmes zones de la couche mince et on forme des motifs en relief.

Un mode de réalisation prévoit que la couche mince comprend un matériau de base, le matériau de base étant, de préférence, un matériau semiconducteur, par exemple du silicium, ou un oxyde, par exemple un oxyde de silicium.

Un autre mode de réalisation prévoit que la couche mince comprend un matériau de base, par exemple un oxyde, de préférence un oxyde de silicium, dans lequel sont disposés des plots, de préférence des plots métalliques, et encore plus préférentiellement des plots en cuivre.

Une variante de réalisation prévoit que le matériau sensible à l'agent de gravure est le matériau de base.

Une autre variante de réalisation prévoit que le matériau sensible à l'agent de gravure correspond aux plots.

Un autre mode de réalisation prévoit que la couche mince comprend des barrières, de préférence des barrières métalliques, et plus particulièrement des barrières en cuivre, formant une protection latérale tout autour des deuxièmes zones.

Selon une variante de réalisation, lors de l'étape de gravure, les barrières et les plots sont gravés.

Selon une autre variante de réalisation, le procédé comprend, après l'étape c), une étape additionnelle au cours de laquelle les barrières et les plots sont gravés.

Un autre mode de réalisation prévoit que le procédé comprend une étape ultérieure au cours de laquelle le substrat-poignée est utilisé pour structurer un autre substrat d'intérêt.

Un autre mode de réalisation prévoit que la couche hydrophobe comprend au moins un composé comprenant un ou plusieurs atomes d'halogènes et une chaine carbonée comprenant au moins 5 atomes de carbone.

Un autre mode de réalisation prévoit que le composé hydrophobe est choisi parmi les silanes, notamment les chlorosilanes, et les polymères, de préférence les polymères fluorés.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D, 1E, 1F, 1G, 1H, 1I et 1J représentent, de manière schématique, différents étapes pour former des motifs sur un substrat, selon un mode de réalisation particulier de l'invention ;
la figure 2 est un cliché photographique d'une plaque comprenant des zones hydrophobes et des zones hydrophiles, obtenue selon un mode de réalisation particulier de l'invention, et sur laquelle une solution aqueuse a été déposée ;
les figures 3A, 3B, 3C et 3D représentent, de manière schématique différentes étapes d'un procédé de structuration d'un substrat d'intérêt selon un autre mode de réalisation particulier, le substrat étant représenté en coupe ;
les figures 3E et 3F représentent, de manière schématique et en vue de dessus, le substrat représenté sur les figures 3C et 3D respectivement, les pointillés représentant la position de la couche hydrophobe ;
les figures 4A, 4B, 4C et 4D représentent, de manière schématique différentes étapes d'un procédé de structuration d'un substrat d'intérêt selon un autre mode de réalisation particulier, le substrat étant représenté en coupe ;
les figures 4E et 4F représentent, de manière schématique et en vue de dessus, le substrat représenté sur les figures 4C et 4D respectivement, les pointillés représentant la position de la couche hydrophobe; et
les figures 5A, 5B et 5C représentent de manière schématique différentes étapes d'un procédé de structuration d'un substrat d'intérêt selon un autre mode de réalisation particulier, le substrat étant représenté en vue de dessus et les pointillés représentant la position de la couche hydrophobe.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures dans une position normale d'utilisation.

Sauf précision contraire, les expressions "environ", "approximativement", "sensiblement", et "de l'ordre de" signifient à 10 % près, de préférence à 5 % près.

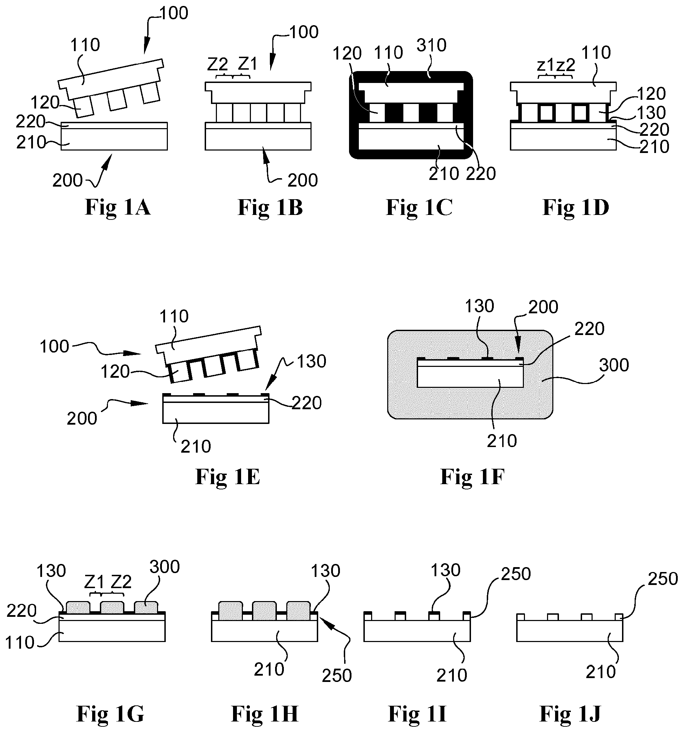

Nous allons maintenant décrire plus en détail le procédé de réalisation de motifs sur un substrat en faisant tout d'abord référence aux figures 1A à 1J.

Le procédé comprend les étapes suivantes :
a) Coller un substrat-poignée 100 sur un substrat d'intérêt 200, le substrat-poignée 100 comprenant une base 110 et des éléments en relief 120 recouvrant la base 110, le substrat d'intérêt 200 comprenant un substrat support 210 recouvert par une couche mince 220, la couche mince 220 comprenant un matériau sensible à un agent de gravure, moyennant quoi la couche mince 220 comprend des premières zones Z1 non recouvertes par les éléments en relief 120 et des deuxièmes zones Z2 recouvertes par les éléments en relief 120 (figures 1A et 1B),
b) Former une couche hydrophobe 130 sur les premières zones Z1 de la couche mince 220, par exemple en mettant en contact l'ensemble obtenu à l'étape a) avec une solution comprenant un composé hydrophobe (typiquement par immersion) (figures 1C et 1D),
c) Séparer le substrat-poignée 100 du substrat d'intérêt 200 (figure 1E),
d) Mettre en contact le substrat d'intérêt 200 avec une solution 300 aqueuse comprenant l'agent de gravure, la couche hydrophobe 130 protégeant les premières zones Z1, moyennant quoi on grave le matériau sensible à l'agent de gravure présent dans les deuxièmes zones Z2 de la couche mince 220 et on forme des motifs 250 en relief (figures 1F à 1H),
e) Le cas échéant, enlever l'excédent de solution 300 (figure 1I) et retirer la couche hydrophobe 130 (figure 1J).

Le substrat-poignée 100 forme un masque dur. Il permet de former des motifs 250 sur le substrat d'intérêt sans mettre en œuvre d'étapes de photolithographie. Le procédé est ainsi simple et rapide à mettre en œuvre.

De plus, avec un seul et même substrat-poignée 100, il est possible de former des motifs sur plusieurs substrats (plaquettes). Le substrat-poignée est réutilisable, ce qui réduit d'autant plus les coûts de procédé.

Préalablement à l'étape a), il est possible de réaliser un ou plusieurs pré-traitements sur la surface du substrat-poignée 100 et/ou sur la surface du substrat d'intérêt 200 de façon à les rendre compatible avec un collage direct.

Le prétraitement peut être choisi parmi les pré-traitements suivants : recuit thermique, plasma, polissage et nettoyage humide.

A titre d'exemple, il est possible de former une couche d'oxyde à la surface du substrat-poignée 100 et/ou de réaliser une étape de polissage sur le substrat-poignée 100 et/ou sur le substrat d'intérêt 200 pour obtenir une rugosité compatible avec un collage direct (typiquement une rugosité inférieure à 0,5 nm RMS). Il est possible de mettre en œuvre des procédés qui combinent, par exemple, un plasma et une solution aqueuse, notamment un plasma oxygène suivi d'un nettoyage humide CARO (H₂SO₄, H₂O₂ en proportion 5 :1) associé avec SC1 (H₂O, NH₃, H₂O₂ en proportion 5 :1 :1 à 70°C).

Lors de l'étape a), le substrat-poignée 100 et le substrat d'intérêt 200 sont mis en contact pour être collés.

Les deux substrats 100, 200 peuvent être assemblés par collage direct. L'utilisation de marques sur les substrats 100, 200 peut faciliter leur alignement. Une précision d'environ 100nm peut être atteinte. Il est également possible de les aligner, sans avoir recours aux marques, en utilisant les bords des substrats ainsi que leur encoche (ou 'notch'). La précision est moindre (+/- 50µm) mais suffisante pour certaines applications.

Le collage direct peut être réalisé à la pression atmosphérique (soit 1013,25 hPa) ou sous vide. L'assemblage n'a pas forcément besoin d'être consolidé par un traitement thermique. Néanmoins, un recuit, à une température de préférence inférieure à 200°C, peut être avantageusement réalisé.

Le substrat-poignée 100 comprend une base 110 et des éléments 120 en relief (piliers ou colonnes). La surface des éléments 120 peut être de différentes formes. Elle peut être carrée, rectangulaire ou encore circulaire. Les éléments 120 en relief ont, par exemple, une hauteur comprise entre 1 µm et 200 µm ou plus spécifiquement entre 10 µm et 100 µm. Ces éléments 120 sont, de préférence, espacés de plus de 10 µm voire de plus de 50 µm afin de permettre l'infiltration de l'agent de gravure (gazeux ou liquide) par capillarité au sein du réseau formés par les éléments 120 en relief.

La base 110 et les éléments en relief peuvent être en des matériaux différents. De préférence, ils sont en un même matériau.

Le substrat-poignée 100 est, de préférence, obtenu à partir d'un substrat massif. Il peut s'agir d'un substrat en métal ou en matériau semi-conducteur par exemple.

Notamment, les éléments 120 en relief du substrat-poignée 100 peuvent être réalisés au moyen d'une étape de photolithographie, par exemple au moyen des sous-étapes suivantes :
- déposer localement une résine sur un substrat,
- graver les parties du substrat non recouvertes par la résine pour former des éléments 120 en relief dans le substrat,
- retirer la résine,
- éventuellement, détourer le substrat.

Le détourage du bord de plaque permet d'éviter un éventuel contact en bord entre le substrat-poignée 100 et le substrat d'intérêt 200.

Le détourage peut être réalisé par exemple par photolithographie/gravure, ou encore par détourage mécanique au moyen d'une scie diamantée. La largeur du détourage est comprise, par exemple, entre 1 et 5 mm et/ou sa profondeur comprise, par exemple, entre 100 et 250 µm.

Lors de l'étape b), on forme une couche hydrophobe sur les premières zones (Z1) de la couche mince (220). La couche peut aussi être appelée film.

Le choix de la couche hydrophobe 130 dépendra, notamment, du substrat d'intérêt 200 et de la solution de gravure 300.

La couche hydrophobe 130 a, par exemple, une épaisseur comprise entre 2 nm et 100 nm.

La couche hydrophobe 130 peut être obtenue à partir d'un polymère, d'un silyle (aussi appelés organo-silylés) ou d'un silane.

Le composé hydrophobe choisi comprend, de préférence, un ou plusieurs groupes halogènes, notamment des groupes fluor ou chlore. De préférence, le composé hydrophobe comprend une chaine carbonée d'au moins 5 atomes de carbone.

Le silane peut être un chlorosilane comme l'octadécyltrichlorosilane (OTS = CH₃(-CH₂)₁₇-SiCl₃) commercialisé par la société Sigma Aldrich.

Les polymères peuvent être des polymères fluorés comme par exemple le polymère Novec^{™} 1720 EGC commercialisé par la société 3M^{™}, l'Optool commercialisé par la société DAIKIN et le polymère Novec^{™} 2202 EGC commercialisé par la société 3M^{™}. Le composé hydrophobe peut être choisi parmi les chlorosilanes comme le perfluorodecyltrichlorosilane (FDTS = Cl₃Si(CH₂)₂(CF₂)₇CF₃) commercialisé par la société Sigma-Aldrich, le perfluorodecyldimethylchlorosilane (FDDMCS = CF₃(CF₂)₇(CH₂)₂(CH₃)₂SiCl) commercialisé par la société Sigma-Aldrich.

De préférence, la couche hydrophobe 130 est déposée par voie liquide, en immergeant l'ensemble formé du substrat poignée 100 et du substrat d'intérêt 200 dans une solution contenant le ou les composés hydrophobes destinés à former la couche hydrophobe 130 sur les premières zones Z1 de la couche mince 220. Le liquide s'infiltre au sein du réseau formés par les éléments 120 en relief. Le détourage facilite l'entrée du liquide au bord des structures collées.

Après l'étape b), une étape de rinçage et, éventuellement, une étape de séchage peuvent être réalisées. Le séchage peut être réalisé par centrifugation.

Un recuit peut permettre de sécher et/ou stabiliser la couche hydrophobe 130.

Lors de l'étape c), le substrat-poignée 100 est séparé du substrat 200. L'assemblage peut être démonté en insérant par exemple un coin entre les deux substrats 100, 200.

Le substrat-poignée 100 peut être utilisé dans un nouveau cycle de collage/gravure. Un nettoyage est, avantageusement, réalisé entre chaque utilisation.

Par exemple, il est possible de le recycler en mettant en œuvre un traitement plasma oxygène suivi d'un nettoyage par voie humide.

Alternativement, comme les bases des éléments en relief 120 du substrat poignée 100 n'ont pas été exposées au composé hydrophobe, elles sont toujours compatibles avec un collage direct. Le substrat poignée 100 peut donc être directement réutilisé.

Lors de l'étape d), le substrat d'intérêt 200 est mis en contact avec une solution 300 aqueuse comprenant l'agent de gravure, par exemple par immersion.

La durée pendant laquelle les deuxièmes zones Z2 sont en contact avec la solution de gravure 300 dépendra de l'épaisseur de matériau à graver.

Lors de l'étape de gravure, il est possible que la couche hydrophobe 130 s'amincisse de quelques dizaines de pourcent. La durée de l'étape de gravure et/ou l'épaisseur de la couche hydrophobe 130 seront choisis de manière à ne pas conduire au retrait complet de la couche hydrophobe 130.

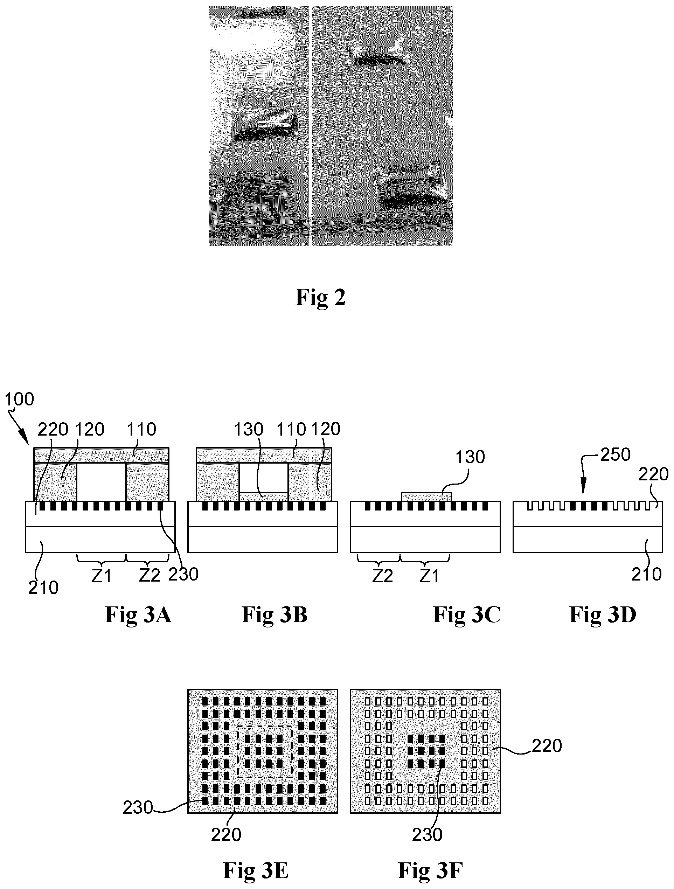

Il est aussi possible d'immerger le substrat 200 entièrement dans la solution 300 puis à de le ressortir immédiatement après. Les premières zones Z1 étant recouvertes par la couche hydrophobe 130, lors de la sortie de plaque, un démouillage de la solution aqueuse 300 sur les premières zones Z1 hydrophobes se produit et la solution 300 se retrouve confinée sur les deuxièmes zones Z2 dépourvues de revêtement hydrophobe (figure 1G et figure 2).

Ainsi, seul le matériau sensible à l'agent de gravure présent dans les deuxièmes zones Z2 est gravé (figure 1H). Des motifs 250 en relief sont ainsi formés.

A l'issue de l'étape d), l'assemblage peut être rincé puis séché. Le séchage peut être réalisé par centrifugation.

Si nécessaire, il est possible de réitérer l'étape d). Ceci est particulièrement avantageux dans le cas où le substrat support 210 est recouvert par un empilement de plusieurs couches minces. Ainsi, il est possible d'utiliser plusieurs agents de gravure pour graver les différentes couches minces de l'empilement.

Lors de l'étape e), la couche hydrophobe 130 peut être retirée des zones Z1. Il est, par exemple, possible d'utiliser un plasma oxygène suivi d'un nettoyage humide CARO associé à un SC1.

Nous allons maintenant décrire plus en détail le substrat d'intérêt et ses différentes configurations possibles.

Le substrat d'intérêt 200 comprend le substrat support 210 recouvert par la couche mince 220 comprenant au moins un matériau sensible à un agent de gravure.

Le substrat d'intérêt 200 peut être un substrat SOI ('Silicon on Insulator'), c'est-à-dire comprenant un substrat support 210 recouvert par une fine couche d'oxyde enterré et une couche de silicium 220. La fine couche d'oxyde peut jouer le rôle de couche d'arrêt de gravure (gravure verticale).

Alternativement, il peut s'agir d'un substrat massif 210 en matériau semiconducteur (silicium par exemple) recouvert d'une couche diélectrique 220, en particulier une couche d'oxyde (oxyde de silicium notamment).

Pour certaines applications, la couche mince 220 peut comprendre un matériau de base (oxyde notamment) et des plots 230, notamment des plots métalliques (figures 3A à 3F). Les plots 230 peuvent être répartis de manière régulière ou irrégulière.

Dans le cas où le matériau sensible à la gravure correspond aux plots 230, le matériau de base n'est pas gravé, et on obtient une couche mince 220 comprenant une pluralité de trous (borgnes ou traversants la couche mince 220) et des motifs 250 en relief (figures 3A à 3F). Les trous sont obtenus après gravure des plots 230. Les motifs en relief 250 correspondent aux premières parties Z1 de la couche mince 220 qui était protégée par la couche hydrophobe 130.

Dans le cas où le matériau sensible à la gravure correspond au matériau de base, les plots 230 ne sont pas gravés, et on obtient un substrat support 210 recouvert par des plots au niveau des deuxièmes zones Z2 et par des motifs 250 au niveau des premières zones Z1. Les motifs 250 peuvent comprendre le matériau de base et les plots.

Les plots 230 peuvent être entourés par une couche protectrice pour les protéger lors de l'étape de gravure. Par exemple, des couches de Ti et TiN ou de Ta et TaN peuvent entourer des plots 230 en cuivre. Des types de gravure spécifiques peuvent alors être employés pour ces matériaux.

Selon un mode de réalisation particulier, des éléments 240 peuvent être disposées au sein de la couche mince 220. Ces éléments 240 forment des parois verticales dans la couche mince 220. Ces éléments 240 entourent les premières zones Z1. Ce sont des barrières de protection 240 permettant d'arrêter la sur-gravure latérale, qui peut parfois accompagner la gravure verticale du matériau gravé. La largeur de cette barrière sera choisie de manière à être suffisamment importante pour arrêter la sur-gravure. Les éléments 240 peuvent avoir des formes identiques ou différentes. Ils sont, bien entendu, en un matériau différent du matériau sensible à l'agent de gravure.

Le positionnement des éléments 240 est choisi de sorte à entourer les premières zones Z1 à protéger.

Lorsque la couche mince 220 comprend des barrières de protection 240, le procédé peut comprendre, après l'étape d), une étape additionnelle au cours de laquelle les barrières de protection 240 sont retirées.

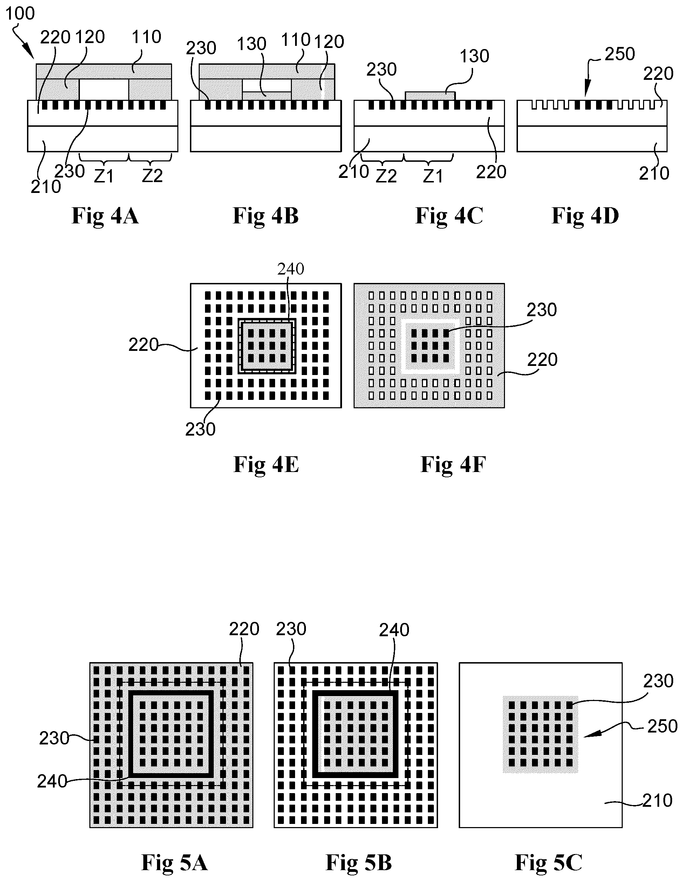

Selon un mode de réalisation particulier, la couche mince 120 comprend un matériau de base, des barrières de protection 240 et des plots 230 (figures 4A à 4F et 5A à 5C).

Selon une première variante de réalisation, les barrières de protection 240 et les plots 230 sont sensibles au même agent de gravure. Les barrières de protection 240 sont, de préférence, en un même matériau que les plots 230. Encore plus préférentiellement, il s'agit d'un métal, tel que le cuivre. Avantageusement, le matériau de base est un oxyde, par exemple un oxyde de silicium. Les barrières de protection 240 et les plots 230 peuvent ainsi être retirés lors d'une unique étape de gravure (figure 4A à 4F). On obtient ainsi une couche mince 220 comprenant une pluralité de trous (borgnes ou traversants la couche mince 220) au niveau des deuxièmes zones Z2. Les premières zones Z1 de la couche mince 220 en regard des éléments en relief 120 sont préservées lors de l'étape de gravure et des motifs en relief 250 sont formés.

Selon une deuxième variante de réalisation représentée sur les figures 5A à 5C, le matériau de base est sensible à l'agent de gravure. Les barrières de protection 240 du matériau de base et les plots 230 ne sont pas sensibles à l'agent de gravure (figure 5A). Les barrières de protection 240 et les plots 230 peuvent être en un même matériau ou en des matériaux différents. Par exemple, les barrières de protection 240 et les plots 230 sont en métal, de préférence en cuivre. Le matériau de base est, par exemple, un oxyde, et notamment un oxyde de silicium. Lors de l'étape de gravure, le matériau de base présent dans les deuxièmes zones Z2 est gravé. Les barrières de protection 240 et les plots métalliques 230 non sensibles à l'élément de gravure sont préservés lors de l'étape de gravure (figure 5B). On obtient une structure comprenant des motifs en relief 250 entourés de barrières de protection 240. Les motifs en relief 250 comprennent le matériau de base dans lequel sont dispersés les plots 230. Les motifs 250 sont entourés par les barrières de protection 240. Entre les motifs 250, au niveau des deuxièmes zones Z2, le substrat support 210 est recouvert par les plots métalliques 230 (figure 5B).

Il est possible de réaliser une étape de gravure supplémentaire (ou plusieurs étapes de gravure supplémentaires) pour retirer les plots métalliques 230 et/ou les barrières de protection 240 (figure 5C).

Les barrières 240 métalliques et/ou les plots métalliques 230 peuvent être inséré dans la couche d'oxyde, par exemple avec un procédé de type de Damascène.

En particulier, il est possible de choisir des barrières 240 métalliques et/ou des plots métalliques 230 en cuivre insérés dans une couche d'oxyde de silicium.

Les barrières 240 métalliques et/ou les plots métalliques 230 peuvent être formés, par exemple, par dépôt physique en phase vapeur (ou PVD pour « Physical Vapor Deposition ») et/ou par dépôt électrochimique (ECD).

De préférence, pour des former des éléments 230 en cuivre par ECD, on déposera préalablement des couches de Ti, TiN et Cu par PVD. Le dépôt par ECD permet de former des éléments de plus fortes épaisseurs que la PVD. Il est également possible de remplacer les couches de Ti et TiN par des couches de Ta et TaN. Les couches de Ti / TiN ou de Ta / TaN jouent le rôle de barrière à la diffusion du cuivre dans le silicium.

Les différentes variantes du procédé précédemment décrit conduisent à l'obtention d'un substrat d'intérêt comprenant un substrat support recouvert par les motifs 250 en relief. L'épaisseur des motifs dépend de l'application visée. Les motifs peuvent être formé du matériau de base (figure 1J) ou du matériau de base dans lequel sont dispersés des plots 230 (figures 3D, 3F, 4D, 4F). Une barrière de protection 240 peut entourer les motifs 250 (figure 5B).

En dehors des motifs 250, plusieurs variantes de réalisation sont possibles, et notamment :
- le substrat support 210 peut être recouvert d'une couche mince 220 présentant des trous borgnes (figures 3F, 4F) ou des trous traversant ladite couche 220,
- des plots 230 peuvent être positionnés sur le substrat support 210 (figure 5B),
- le substrat support 210 peut présenter une surface libre (i.e. en dehors des motifs, aucun élément ne recouvre le substrat support 210) (figures 1J, 5C).

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

### Exemples illustratifs et non limitatifs de différents modes de réalisation

Dans les exemples suivants, les substrats sont réalisés à partir de plaquettes de silicium de 200 mm de diamètre.

### Exemple 1

Le substrat poignée 100 est fabriqué à partir d'une plaquette de silicium ayant subi une oxydation de façon à obtenir en surface un film de 2 µm d'oxyde de silicium. Un procédé de photolithographie/gravure permet de former des éléments en relief 120 de 10 x 10 mm² d'une épaisseur de 100 µm. On réalise un détourage du bord du substrat 100 à la scie diamantée. Le détourage a une largeur de 3 mm et une profondeur 200 µm. La surface d'oxyde de la plaquette est nettoyée par un plasma O₂ suivi d'un nettoyage par voie humide CARO, SC1 de façon à la rendre compatible avec un procédé de collage direct.

Le substrat d'intérêt 200 est une plaquette SOI comprenant un substrat massif 210 recouvert par un film de silicium 220 d'une épaisseur de 205 nm et une couche d'oxyde enterré de 400 nm. Le substrat d'intérêt 200 subit un nettoyage de façon par voie humide de façon à le rendre compatible avec un procédé de collage direct.

On colle directement les deux substrats 100, 200. L'assemblage est immergé pendant 2 min dans une solution de OTS dans l'isooctane. L'assemblage est ensuite rincé par immersion dans l'isooctane puis séchée par centrifugation. Un film hydrophobe 130 est formé sur les zones Z1 de la couche mince 220 non recouvertes par les éléments en relief 120 du substrat poignée 100.

On démonte le substrat-poignée 100 en insérant un coin dans la structure.

On obtient une plaque 200 comprenant des zones Z1 hydrophobes en dehors des zones Z2 qui étaient protégées par les éléments en relief 120 du substrat poignée 100.

Cette plaque 200 est trempée dans une solution aqueuse de TMAH à 5% massique. Après sa sortie du liquide, la plaque 200 est placée 3 min à l'horizontal sur une plaque chauffante à 70° puis rincée dans l'eau et séchée par centrifugation. La couche de silicium 200 exposé au TMAH est gravé jusqu'à la couche d'oxyde enterré qui joue le rôle de couche d'arrêt. On élimine le film hydrophobe 130 par un traitement plasma oxygène et on nettoie la surface par voie humide (CARO et SC1).

La plaque de silicium 200 obtenue présente des motifs 250 (plots) de silicium de 10 x 10 mm² ayant une épaisseur de 205 nm.

### Exemple 2

Le substrat poignée 100 est obtenu à partir d'une plaquette de silicium comme décrit dans l'exemple 1. Il présente des éléments en relief 120 rectangulaires de 10 x 5 mm² d'une épaisseur de 15 µm.

Une plaquette (substrat) 200 subit une oxydation de façon à former un film 220 de 100 nm d'oxyde à sa surface. Le substrat 200 est nettoyé par voie humide de façon à le rendre compatible avec un procédé de collage direct.

On colle directement les deux substrats 100, 200. L'assemblage obtenu est immergé pendant 2 min dans le liquide 310 NOVEC 1720 EGC. L'assemblage est ensuite rincé par immersion dans le solvant NOVEC 7100 EGC puis séché par centrifugation. On démonte le substrat poignée 100 en insérant un coin dans la structure. Le substrat d'intérêt 200 subit un traitement thermique de 15 min à 135°C.

On obtient un substrat d'intérêt 200 dont la couche mince 220 comprend des zones Z1 hydrophobes en dehors des zones Z2 initialement protégées par les éléments en relief 120 du substrat poignée 100.

Le substrat d'intérêt 200 est, ensuite, immergé dans une solution aqueuse de HF à 5 % volumique. Après sa sortie du liquide, la plaque 200 est placée à l'horizontale pendant 3 min, puis rincée par immersion dans l'eau et séchée par centrifugation. La partie de l'oxyde de silicium 220 exposée à la solution de HF est gravée. On élimine le film hydrophobe 130 par un traitement plasma oxygène et on nettoie la surface par voie humide (CARO et SC1).

On obtient un substrat 200 de silicium qui présente des motifs 250 (plots) rectangulaires d'oxyde de silicium de 10 x 5 mm² d'une épaisseur de 100 nm.

### Exemple 3

Un substrat-poignée 100 est fabriqué à partir d'une plaquette de silicium comme décrit dans l'exemple 1. Le substrat présente des éléments 120 cylindriques de 5mm de diamètre d'une épaisseur de 60 µm.

Sur une plaquette, on vient déposer 400 nm d'oxyde à partir de TEOS. On dépose ensuite par PVD des couches de Ti, TiN et Cu d'une épaisseur de 10, 50 et 200 nm. Enfin un traitement électrochimique par ECD permet de déposer, ensuite, un film 220 de Cu de 300 nm. Une étape de polissage du cuivre retire une épaisseur de cuivre de 200 nm et permet de préparer la surface du substrat pour un collage direct.

On colle directement les deux substrats 100, 200. L'assemblage est immergé pendant 2 min dans une solution 310 de FDTS dans l'isooctane. L'assemblage est ensuite rincé par immersion dans l'isooctane puis séché par centrifugation. Le substrat poignée 100 est retiré en insérant un coin dans la structure.

On obtient sur la plaque 200 des zones Z1 hydrophobes en dehors des zones Z2 protégées par les éléments en relief 120 lors du collage avec le substrat poignée 100.

La plaque 200 est immergée dans une solution aqueuse de DSP (H₂SO₄/H₂O₂/H₂O en proportion 1/2/50) de façon à graver les couches de cuivre. Après la sortie du liquide, la plaque 200 est placée à l'horizontale pendant 3 min. L'assemblage est ensuite rincé par immersion dans l'eau puis séché par centrifugation. La couche de cuivre 220 est gravée selon les motifs définis par les éléments en relief 120 du substrat poignée 100.

La plaque 200 est ensuite immergée dans une solution SC1. Après la sortie du liquide, la plaque 200 est placée à l'horizontale sur une plaque chauffante à 70°C pendant 2 min puis rincée et séchée. Les couches de Ti et TiN sont gravées selon les motifs définis par les éléments en relief 120 du substrat poignée 100. On élimine le film hydrophobe 130 par un traitement plasma oxygène puis on nettoie la surface par voie humide (CARO et SC1).

On obtient une plaque d'intérêt 200 comprenant un substrat support 210 en silicium recouvert par des motifs 250 en relief (plots) cylindriques de cuivre de 5 mm² ayant une épaisseur de 300 nm.

## Revendications

1. Procédé de réalisation de motifs sur un substrat comprenant les étapes suivantes :
a) Coller un substrat-poignée (100) sur un substrat d'intérêt (200), le substrat-poignée (100) comprenant une base (110) et des éléments en relief (120) recouvrant la base (110), le substrat d'intérêt (200) comprenant un substrat support (210) recouvert par une couche mince (220), la couche mince (220) comprenant un matériau sensible à un agent de gravure, moyennant quoi la couche mince (220) comprend des premières zones (Z1) non recouvertes par les éléments en relief (120) et des deuxièmes zones (Z2) recouvertes par les éléments en relief (120),
b) Former une couche hydrophobe (130) sur les premières zones (Z1) de la couche mince (220), par exemple en mettant en contact l'ensemble obtenu à l'étape a) avec une solution comprenant un composé hydrophobe,
c) Séparer le substrat-poignée (100) du substrat d'intérêt (200),
d) Mettre en contact le substrat d'intérêt (200) avec une solution (300) aqueuse comprenant l'agent de gravure, moyennant quoi on grave le matériau sensible à l'agent de gravure présent dans les deuxièmes zones (Z2) de la couche mince (220) et on forme des motifs (250) en relief.

2. Procédé selon la revendication 1, **caractérisé en ce que** la couche mince (220) comprend un matériau de base, le matériau de base étant, de préférence, un matériau semiconducteur, par exemple du silicium, ou un oxyde, par exemple un oxyde de silicium.

3. Procédé selon l'une quelconque des revendications précédentes, **caractérisé en ce que** la couche mince (220) comprend un matériau de base, par exemple un oxyde, de préférence un oxyde de silicium, dans lequel sont disposés des plots (230), de préférence des plots (230) métalliques, et encore plus préférentiellement des plots (230) en cuivre.

4. Procédé selon la revendication 3, **caractérisé en ce que** le matériau sensible à l'agent de gravure est le matériau de base.

5. Procédé selon la revendication 3, **caractérisé en ce que** le matériau sensible à l'agent de gravure correspond aux plots (230).

6. Procédé selon l'une quelconque des revendications précédentes, **caractérisé en ce que** la couche mince (220) comprend des barrières (240), de préférence des barrières (240) métalliques, et plus particulièrement des barrières en cuivre, formant une protection latérale tout autour des deuxièmes zones (Z2).

7. Procédé selon les revendications 5 et 6, **caractérisé en ce que** lors de l'étape de gravure, les barrières (240) et les plots (230) sont gravés.

8. Procédé selon les revendications 4 et 6, **caractérisé en ce que** le procédé comprend, après l'étape c), une étape additionnelle au cours de laquelle les barrières (240) et les plots (230) sont gravés.

9. Procédé selon l'une quelconque des revendications précédentes, **caractérisé en ce que** le procédé comprend une étape ultérieure au cours de laquelle le substrat-poignée (100) est utilisé pour structurer un autre substrat d'intérêt.

10. Procédé selon l'une quelconque des revendications précédentes, **caractérisé en ce que** la couche hydrophobe comprend au moins un composé comprenant un ou plusieurs atomes d'halogènes et une chaine carbonée comprenant au moins 5 atomes de carbone.

11. Procédé selon la revendication précédente, **caractérisé en ce que** le composé hydrophobe est choisi parmi les silanes, notamment les chlorosilanes, et les polymères, de préférence les polymères fluorés.

## Patentansprüche

1. Ein Verfahren zum Ausbilden von Mustern auf einem Substrat, das die folgenden Schritte aufweist:
a) Verbinden eines Arbeitssubstrats (100) mit einem Zielsubstrat (200), wobei das Arbeitssubstrat (100) eine Basis (110) und erhöhte Elemente (120) aufweist, die die Basis (110) bedecken, und das Zielsubstrat (200) ein Trägersubstrat (210) aufweist, das mit einem Dünnfilm (220) bedeckt ist, wobei der Dünnfilm (220) ein Material aufweist, das gegenüber einem Ätzmittel empfindlich ist, wobei der Dünnfilm (220) erste Bereiche (Z1), die nicht mit den erhöhten Elementen (120) bedeckt sind, und zweite Bereiche (Z2), die mit den erhöhten Elementen (120) bedeckt sind, aufweist,
b) Ausbilden einer hydrophoben Schicht (130) auf den ersten Bereichen (Z1) des Dünnfilms (220), beispielsweise durch Inkontaktbringen der in Schritt a) erhaltenen Anordnung mit einer Lösung, die eine hydrophobe Verbindung aufweist,
c) Trennen des Arbeitssubstrats (100) vom Zielsubstrat (200),
d) Inkontaktbringen des Zielsubstrats (200) mit einer wässrigen Lösung (300), die das Ätzmittel aufweist, wodurch das Material, das gegenüber dem Ätzmittel empfindlich ist, das in den zweiten Bereichen (Z2) des Dünnfilms (220) vorhanden ist, geätzt wird und erhöhte Muster (250) ausgebildet werden.

2. Das Verfahren nach Anspruch 1, **dadurch gekennzeichnet, dass** der Dünnfilm (220) ein Basismaterial aufweist, wobei das Basismaterial vorzugsweise ein Halbleitermaterial, beispielsweise Silizium, oder ein Oxid, beispielsweise ein Siliziumoxid, ist.

3. Das Verfahren nach einem der vorstehenden Ansprüche, **dadurch gekennzeichnet, dass** der Dünnfilm (220) ein Basismaterial aufweist, beispielsweise ein Oxid, vorzugsweise ein Siliziumoxid, mit darin angeordneten Pads (230), vorzugsweise Metallpads (230) und noch bevorzugter Kupferpads (230).

4. Das Verfahren nach Anspruch 3, **dadurch gekennzeichnet, dass** das Material, das gegenüber dem Ätzmittel empfindlich ist, das Basismaterial ist.

5. Das Verfahren nach Anspruch 3, **dadurch gekennzeichnet, dass** das Material, das gegenüber dem Ätzmittel empfindlich ist, den Pads (230) entspricht.

6. Das Verfahren nach einem der vorstehenden Ansprüche, **dadurch gekennzeichnet, dass** die Dünnschicht (220) Barrieren (240) aufweist, vorzugsweise Metallbarrieren (240) und noch bevorzugter Kupferbarrieren, die einen seitlichen Schutz rund um die zweiten Bereiche (Z2) ausbilden.

7. Das Verfahren nach den Ansprüchen 5 und 6, **dadurch gekennzeichnet, dass** während des Ätzschritts die Barrieren (240) und die Pads (230) geätzt werden.

8. Das Verfahren nach den Ansprüchen 4 und 6, **dadurch gekennzeichnet, dass** das Verfahren nach Schritt c) einen zusätzlichen Schritt aufweist, während dessen die Barrieren (240) und die Pads (230) geätzt werden.

9. Das Verfahren nach einem der vorstehenden Ansprüche, **dadurch gekennzeichnet, dass** das Verfahren einen nachfolgenden Schritt aufweist, in dem das Arbeitssubstrat (100) verwendet wird, um ein anderes Zielsubstrat zu strukturieren.

10. Das Verfahren nach einem der vorstehenden Ansprüche, **dadurch gekennzeichnet, dass** die hydrophobe Schicht wenigstens eine Verbindung aufweist, die ein oder eine Vielzahl von Halogenatomen und eine Kohlenstoffkette mit wenigstens 5 Kohlenstoffatomen aufweist.

11. Das Verfahren nach dem vorstehenden Anspruch, **dadurch gekennzeichnet, dass** die hydrophobe Verbindung aus Silanen, insbesondere Chlorsilanen, und Polymeren, vorzugsweise Fluorpolymeren, ausgewählt ist.

## Claims

1. Method of forming patterns on a substrate comprising the following steps:
a) Bonding a handle substrate (100) to a substrate of interest (200), the handle substrate (100) comprising a base (110) and raised elements (120) covering the base (110), the substrate of interest (200) comprising a support substrate (210) covered with a thin film (220), the thin film (220) comprising a material sensitive to an etchant, whereby the thin film (220) comprises first areas (Z1) not covered with the raised elements (120) and second areas (Z2) covered with the raised elements (120),
b) Forming a hydrophobic layer (130) on the first areas (Z1) of the thin film (220), for example by placing into contact the assembly obtained at step a) with a solution comprising a hydrophobic compound,
c) Separating the handle substrate (100) from the substrate of interest (200),
d) Placing into contact the substrate of interest (200) with an aqueous solution (300) comprising the etchant, whereby the material sensitive to the etchant present in the second areas (Z2) of the thin film (220) is etched and raised patterns (250) are formed.

2. Method according to claim 1, **characterized in that** the thin film (220) comprises a base material, the base material preferably being a semiconductor material, for example silicon, or an oxide, for example a silicon oxide.

3. Method according to any of the foregoing claims, **characterized in that** the thin film (220) comprises a base material, for example an oxide, preferably a silicon oxide, having pads (230), preferably metal pads (230), and even more preferably copper pads (230), arranged therein.

4. Method according to claim 3, **characterized in that** the material sensitive to the etchant is the base material.

5. Method according to claim 3, **characterized in that** the material sensitive to the etchant corresponds to the pads (230).

6. Method according to any of the foregoing claims, **characterized in that** the thin film (220) comprises barriers (240), preferably metal barriers (240), and more particularly copper barriers, forming a lateral protection all around the second areas (Z2).

7. Method according to claims 5 and 6, **characterized in that** during the etch step, the barriers (240) and the pads (230) are etched.

8. Method according to claims 4 and 6, **characterized in that** the method comprises, after step c), an additional step during which the barriers (240) and the pads (230) are etched.

9. Method according to any of the foregoing claims, **characterized in that** the method comprises a subsequent step during which the handle substrate (100) is used to structure another substrate of interest.

10. Method according to any of the foregoing claims, **characterized in that** the hydrophobic layer comprises at least one compound comprising one or a plurality of halogen atoms and a carbon chain comprising at least 5 carbon atoms.

11. Method according to the foregoing claim, **characterized in that** the hydrophobic compound is selected from among silanes, in particular chlorosilanes, and polymers, preferably fluoropolymers.
